# EUROPEAN PATENT SPECIFICATION

(11) **EP 0 421 743 B1**
(45) Date of publication and mention of the grant of the patent: **03.01.1996**
(21) Application number: 90310795.1
(22) Date of filing: 03.10.1990
(51) Int. Cl.: H05K 7/20

(54) **Coolant supply apparatus for liquid-cooled electronic device**
Kühlmittelzufuhrvorrichtung für elektronische Einrichtung mit Flüssigkeitskühlung
Appareil d'alimentation en refroidissant pour dispositif électronique refroidi par liquide

(30) Priority: 03.10.1989 JP 259164/89
(43) Date of publication of application: 10.04.1991
(73) Proprietor: NEC CORPORATION, Tokyo (JP)
(72) Inventor: Umezawa, Kazuhiko, c/o NEC Corporation, Minato-ku, Tokyo 108-01 (JP)
(74) Representative: Smith, Philip Antony

(56) References cited:
- EP-A- 0 313 473
- US-A- 2 692 961
- US-A- 3 334 684
- IBM TECHNICAL DISCLOSURE BULLETIN. vol. 14, no. 11, April 1972, NEW YORK US pages 3375-3376; P.J. CUNAVELIS ET AL: 'DIELECTRIC COOLING SYSTEM'

## Description

### Background of the Invention

The present invention relates to an apparatus for supplying a coolant to an electronic device, such as a large data processor, which is cooled by a liquid coolant.

In an electronic device such as a large data processor, semiconductor IC elements used for the device are formed into large scale integrated circuits, and the packing density is greatly increased to optimize the performance of the device. For this reason, the heating density in the device is greatly increased. For such a device, a forced-air cooling system using a cooling fan lacks cooling performance. Therefore, several types of cooling methods have been recently proposed and put into practice, in which a liquid coolant, e.g., water, having a larger heat capacity than air is circulated in a device to cool the device by dissipating generated heat.

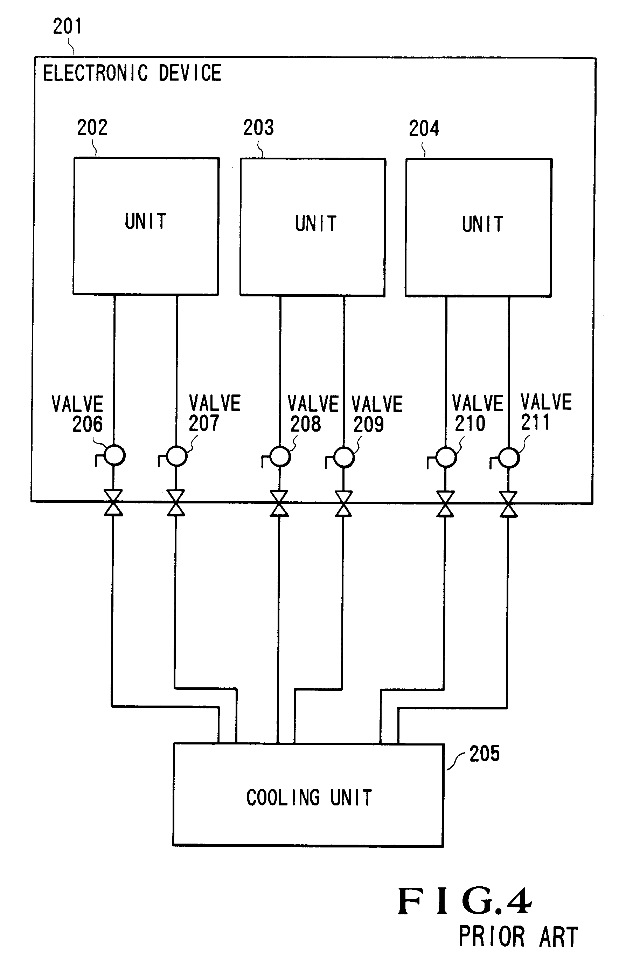

In such a liquid-cooled device, as shown in Fig. 4, a device 201 is divided into a plurality of units 202 to 204, and a liquid coolant is supplied to the respective units through different systems. With such an arrangement, even if supply of the liquid coolant to a certain unit must be stopped to perform maintenance thereof, the liquid coolant can be kept supplied to other units. Referring to Fig. 4, the liquid coolant is independently supplied to the units 202, 203, and 204 from a cooling unit 205. When supply of the liquid coolant to the unit 202 is to be stopped, only valves 206 and 207 arranged at the inlet and outlet of the cooling supply system of the unit 202 are required to be closed. In this case, since valves 208 to 211 are open, supply of the liquid coolant to the units 203 and 204 is not stopped.

In the above-described supply apparatus, however, if a device is divided into small units, coolant pipe systems of the same number as that of the units must be installed. This complicates the structure of the cooling unit. In addition, since the number of pipes installed between the cooling unit and the electronic device is increased, the time required for the installation of the pipes is increased. Moreover, the complicated pipe systems in the electronic device interfere with an increase in packing density in the device.

From US - A - 3334684 there is further known a cooling system for data processing equipment.

### Summary of the Invention

It is an object of the present invention to provide a coolant supply apparatus for a liquid-cooled electronic device, which can simplify the structure of a cooling unit, facilitate installation, and can protect the device against failure to open valves.

According to the present invention, there is provided a coolant supply apparatus as defined in the appendant claim.

### Brief description of the drawings

Fig. 1 is a block diagram showing an embodiment of the present invention;
Figs. 2A and 2B are views showing a flow sensor;

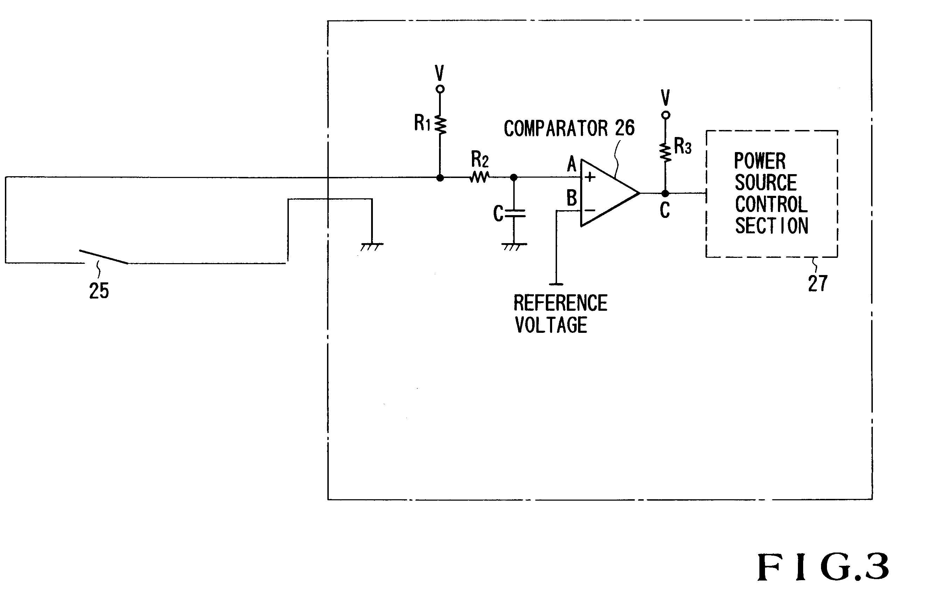

Fig. 3 is a circuit diagram of a power source controller; and
Fig. 4 is a block diagram showing a conventional coolant supply apparatus for a liquid-cooled electronic device. Description of the Preferred Embodiment

The present invention will be described below with reference to the accompanying drawings.

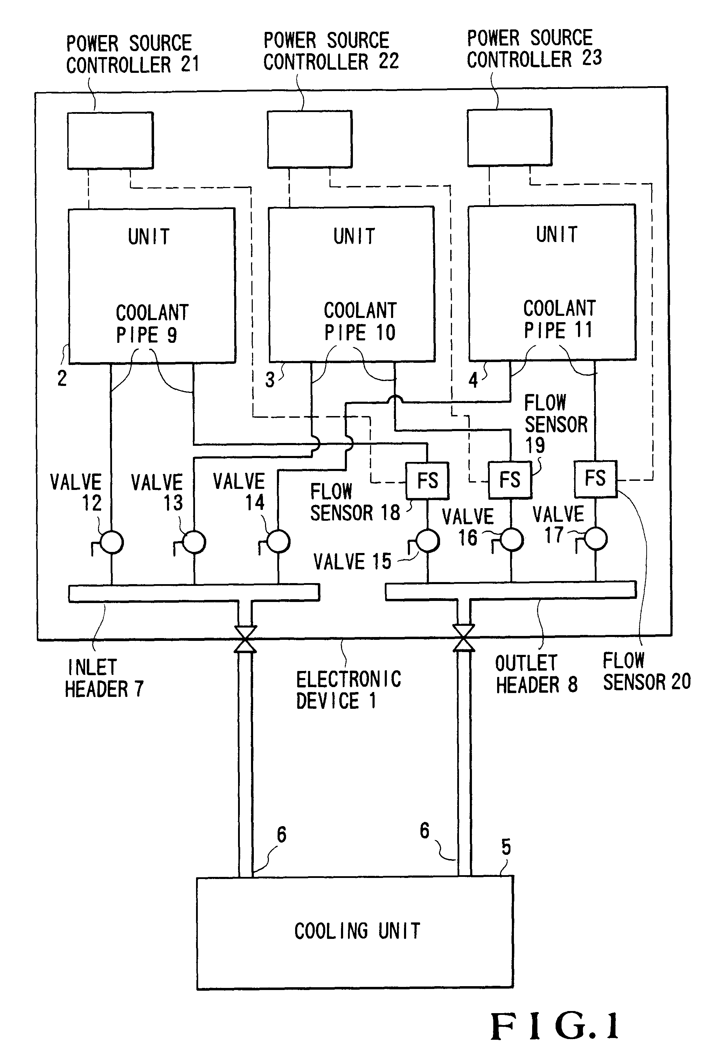

Fig. 1 shows an embodiment of the present invention. Referring to Fig. 1, reference numeral 1 denotes an electronic device constituted by a plurality of units, i.e., a unit 2, a unit 3, and unit 4; 5, a cooling unit, connected to the electronic device 1 through a pair of hoses, for circulating a liquid coolant in the electronic device 1; and 7 and 8, inlet and outlet headers, respectively, for distributing the liquid coolant supplied through one system to the respective units.

Valves 12 to 17 are arranged at the connecting portions between the header 7 and pipes 9, 10, and 11 for supplying the coolant to the units 2, 3, and 4. When supply of the coolant to a given unit is to be stopped, corresponding valves are closed. For example, when supply of the coolant to the unit 3 is to be stopped, the valves 13 and 16 are closed. Flow sensors 18, 19, and 20 are arranged in the coolant systems of the respective units on a side opposite to the outlet valves 15 to 17 and the header 8 so as to detect whether the coolant flows in the coolant systems of the respective units. Reference numerals 21, 22, and 23 denote power source controllers of the units 2, 3, and 4, respectively. Signals from the flow sensors 18, 19, and 20 are respectively supplied to the power controllers 21, 22, and 23 of the units 2, 3, and 4. The liquid coolant supplied from the cooling unit 5 flows to the inlet header 7 through the hose 6. The coolant is then distributed by the header 7 to flow to the pipes 9, 10, 11 for respectively supplying the coolant to the units 2, 3, and 4. After cooling the units 2, 3, and 4, the coolant is collected by the outlet header 8. The coolant then returns to the cooling unit 5 through the hose 6.

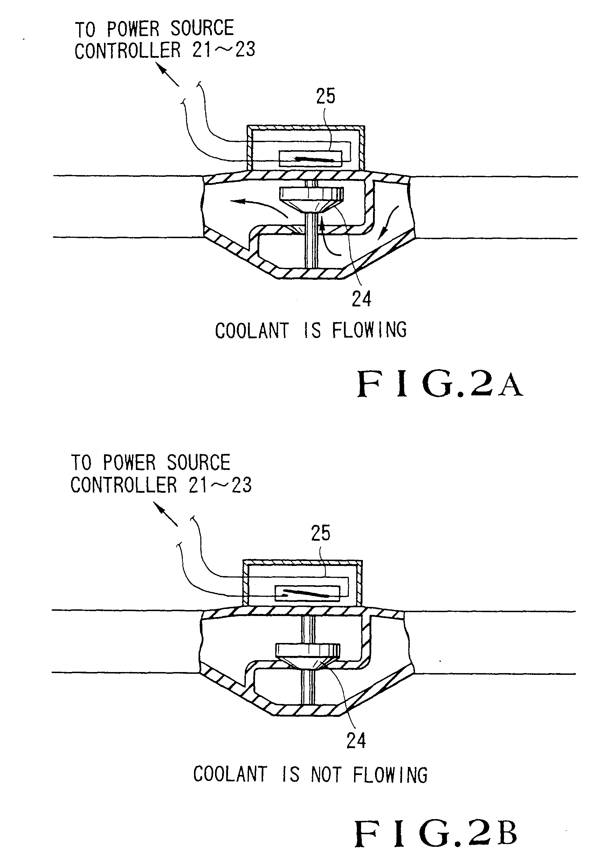

As shown in Figs. 2A and 2B, each of the flow sensors 18 to 20 is designed such that a reed switch 25 is opened/closed depending on the position of a float 24 with a magnet. Whether the coolant is flowing or not is detected on the basis of this opening/closing operation of the reed switch 25. Fig. 2A shows a case wherein the coolant is flowing. Fig. 2B shows a case wherein no coolant is flowing. More specifically, the voltage of an input A to a comparator is changed in accordance with opening/closing of the reed switch 25. When the input A is compared with a reference voltage input B, the signal level of an output C from the comparator 26 is changed. Assume that a given one of the flow sensors 18 to 20 detects the flow of the coolant upon input of the output C to the a power source control section 27. In this case, supply of power to a corresponding one of the units is allowed. In contrast to this, assume that no coolant flow is detected. In this case, if power is being supplied to a corresponding unit, the power is disconnected or inhibited.

If, for example, supply of the coolant to the unit 2 is to be stopped to perform maintenance thereof, the valves 12 and 15 are closed. At this time, the flow sensor 18 detects that no coolant flows in the pipe system 9 of the unit 2. The detection signal from the sensor 18 is then output to the power source controller 21 so that no power can be supplied to the unit 2 while the flow sensor 18 detects that no coolant flows in the pipe system 9. With this arrangement, even if an operator tries to turn on the power source of the unit 2 while he/she forgets to open the valves 12 and 13 and no coolant is flowing after the maintenance is completed, the power source is not turned on, thus protecting the device.

With the above-described arrangement, since only one pipe system is required between the cooling unit and the electronic device, the structure of the cooling unit can be simplified, and installation does not require much time. When supply of the coolant to a given unit in the electronic device is required to be stopped for the maintenance of the unit, only the corresponding valves need to be closed. Even if an operator forgets to open given valves, since a corresponding flow sensor detects it and sends a detection signal to the power source controller so as not to turn on the power source of a corresponding unit, failure of the device can be prevented, which is caused when the power source is turned on while no coolant is flowing.

As has been described above, according to the present invention, only one coolant system is arranged between an electronic device and a cooling unit, and a coolant is distributed to the respective units in the device by headers arranged therein. In addition, valves and a flow sensor are arranged at the outlet and inlet of the coolant system to each unit in the device. Moreover, a signal from each flow sensor is supplied to a power source controller of a corresponding unit to inhibit the power source of the unit from being turned on if no coolant is supplied thereto. With these arrangements, the structure of the cooling unit can be simplified, installation is facilitated, and the device can be protected against failure to open valves.

## Claims

1. A coolant supply apparatus for circulating/supplying a liquid coolant to a plurality of units (2,3,4) of a liquid-cooled electronic device, comprising:
an inlet header (7) to which the liquid coolant is supplied from a cooling unit (5);
an outlet header (8) for returning the liquid coolant to the cooling unit;
a plurality of inlet pipes, each connecting one of the units, via a respective inlet valve (12,13,14) for regulating the flow of coolant, to the inlet header;
a plurality of outlet pipes, each connecting one of the units, via a respective outlet valve (15,16,17) for regulating the flow of coolant, to the outlet header;
a plurality of flow sensors (18,19,20), each flow sensor being arranged for sensing coolant flow rate in a respective outlet pipe between the respective unit and the respective outlet valve, and having a body (24) comprising a magnet moveably supported within the outlet pipe for motion under the influence of the coolant flow between a first position and a second position depending on the coolant flow rate and a reed switch (25) responsive to the position of the body (24) for generating an output signal indicative of a decrease in the coolant flow rate below a predetermined flow rate; and,
a power source controller (27), for controlling the power supply to each unit, responsive to the output signal from each flow sensor to inhibit the power supply to the corresponding unit in the event that a flow sensor generates a signal indicating a decrease in flow rate below the predetermined flow rate.

## Patentansprüche

1. Kühlmittelzufuhrvorrichtung zum Umwälzen/Zuführen eines flüssigen Kühlmittels in bzw. zu mehreren Einheiten (2, 3, 4) einer elektronischen Einrichtung mit Flüssigkeitskühlung, mit:
einem Verteilerrohr (7), dem das flüssige Kühlmittel von einer Kühleinheit (5) zugeführt wird;
einem Sammelrohr (8) zur Rückführung des flüssigen Kühlmittels zu der Kühleinheit;
mehreren Einlaßrohren, wobei jedes eine der Einheiten über ein entsprechendes Einlaßabsperrorgan (12, 13, 14) zum Regulieren des Durchflusses eines Kühlmittels mit dem Verteilerrohr verbindet;
mehreren Auslaßrohren, wobei jedes eine der Einheiten über ein entsprechendes Auslaßabsperrorgan (15, 16, 17) zum Regeln des Durchflusses eines Kühlmittels mit dem Sammelrohr verbindet;
mehreren Strömungssensoren (18, 19, 20), wobei jeder Strömungssensor zum Erfassen einer Kühlmitteldurchflußrate in einem entsprechenden Auslaßrohr zwischen der entsprechenden Einheit und dem entsprechenden Auslaßventil eingerichtet ist und einen Körper (24) aufweist, der aufweist: einen Magneten, der im Auslaßrohr beweglich gelagert, damit er sich unter dem Einfluß des Kühlmittelstroms zwischen einer ersten Position und einer zweiten Position in Abhängigkeit von der Durchflußrate des Kühlmittels bewegen kann, und einen Reed-Schalter (25), der auf die Position des Körpers (24) anspricht, zum Erzeugen eines Ausgangssignals, das eine Absinken der Durchflußrate unter eine vorbestimmte Rate anzeigt; und
einem Stromquellenregler (27), zum Regeln der Stromzufuhr zu jeder Einheit, der auf das Ausgangssignal von jedem Strömungssensor anspricht, um die Stromzufuhr zu der jeweiligen Einheit für den Fall zu verhindern, daß ein Strömungssensor ein Signal erzeugt, das ein Absinken der Durchflußrate unter die vorbestimmte Durchflußrate anzeigt.

## Revendications

1. Dispositif d'alimentation en agent réfrigérant destiné à fournir et faire circuler un liquide de refroidissement dans une pluralité d'unités (2, 3, 4) d'un dispositif électronique refroidi par liquide, comprenant :
un collecteur d'entrée (7) auquel le liquide de refroidissement est fourni à partir d'une unité de refroidissement (5),
un collecteur de sortie (8) destiné à renvoyer le liquide de refroidissement à l'unité de refroidissement,
une pluralité de conduites d'entrée, reliant chacune l'une des unités, par l'intermédiaire d'une vanne d'entrée respective (12, 13, 14) destinée à commander la circulation d'agent réfrigérant, au collecteur d'entrée,
une pluralité de conduites de sortie, reliant chacune l'une des unités, par l'intermédiaire d'une vanne de sortie respective (15, 16, 17) destinée à commander la circulation d'agent réfrigérant, au collecteur de sortie,
une pluralité de capteurs de débit (18, 19, 20), chaque capteur de débit étant agencé pour détecter le débit de l'agent réfrigérant dans une conduite de sortie respective entre l'unité respective et la vanne de sortie respective, et comportant un corps (24) comprenant un aimant supporté de manière mobile à l'intérieur de la conduite de sortie pour se déplacer sous l'influence de la circulation d'agent réfrigérant entre une première position et une seconde position en fonction du débit d'agent réfrigérant, et un relais à anche (25) sensible à la position du corps (24) pour générer un signal de sortie indiquant une diminution du débit d'agent réfrigérant au-dessous d'un débit prédéterminé, et
un contrôleur de source de courant (27) destiné à commander l'alimentation en courant de chaque unité, sensible aux signaux de sortie provenant de chaque capteur de débit pour empêcher l'alimentation en courant de l'unité correspondante au cas où un capteur de débit génère un signal indiquant une diminution de débit au-dessous du débit prédéterminé.
